# EUROPEAN PATENT APPLICATION

(11) **EP 4 063 934 A1**
(43) Date of publication of application: **28.09.2022**
(21) Application number: 20891300.4
(22) Date of filing: 16.09.2020
(51) Int. Cl.: G02B 26/10, B81B 3/00, G02B 5/08, G02B 26/08

(54) **MIRROR UNIT**

(30) Priority: 21.11.2019 JP 2019210634; 12.03.2020 JP 2020043211
(71) Applicant: Hamamatsu Photonics K.K., Hamamatsu-shi, Shizuoka 435-8558 (JP)
(72) Inventor: SUZUKI Daiki, Hamamatsu-shi, Shizuoka 435-8558 (JP); IDE Tomoyuki, Hamamatsu-shi, Shizuoka 435-8558 (JP)
(74) Representative: Hoffmann Eitle
(86) International application number: PCT/JP2020/035054
(87) International publication number: WO 2021/100301

(57) **Abstract**

A mirror unit includes a mirror device includes a support portion and a movable mirror portion configured to be movable with respect to the support portion, and a package including a light incident opening and accommodating and holding the mirror device such that light incident from the light incident opening is able to be incident on the movable mirror portion. The package is provided with a ventilation port communicating an inside and an outside of the package.

## Description

### Technical Field

An aspect of the present disclosure relates to a mirror unit.

### Background Art

Mirror units including a light scanning device that has a movable mirror portion and a package that accommodates the light scanning device are known (for example, refer to Patent Literature 1 and Patent Literature 2). In such mirror units, a light incident opening of a package main body is blocked by a window member, and the inside of the package is sealed in an airtight manner.

### Citation List

### Patent Literature

[Patent Literature 1] Japanese Unexamined Patent Publication No. 2018-17832
[Patent Literature 2] Japanese Unexamined Patent Publication No. 2016-99567

### Summary of Invention

### Technical Problem

In such mirror units described above, there is concern that dew condensation may occur in a window member due to a temperature difference between the inside and the outside of a package. An object of an aspect of the present disclosure is to provide a mirror unit in which occurrence of dew condensation inside a package can be curbed.

### Solution to Problem

A mirror unit according to an aspect of the present disclosure includes a mirror device including a support portion and a movable mirror portion configured to be movable with respect to the support portion, and a package including a light incident opening and accommodating and holding the mirror device such that light incident from the light incident opening is able to be incident on the movable mirror portion. The package is provided with a ventilation port communicating an inside and an outside of the package.

In this mirror unit, ventilation between the inside and the outside of the package can be achieved via the ventilation port. As a result, occurrence of dew condensation inside the package can be curbed.

A smallest width of the ventilation port in a predetermined direction may be smaller than a smallest distance between the movable mirror portion and a part whose position is fixed in the mirror unit. In this case, hindrance to operation of the movable mirror portion due to dust which has entered the inside of the package through the ventilation port can be curbed.

The movable mirror portion may include a movable portion and a mirror provided on the movable portion. A smallest width of the ventilation port in a predetermined direction may be smaller than a smallest distance between the support portion and the movable portion when viewed in a direction perpendicular to the mirror. In this case, having a situation where dust which has entered the inside of the package through the ventilation port is sandwiched between the support portion and the movable portion can be curbed, and thus hindrance to operation of the movable mirror portion due to dust can be curbed.

A smallest width of the ventilation port in a predetermined direction may be smaller than a smallest distance between the movable mirror portion and a part whose position is fixed in the mirror unit when the movable mirror portion has moved to a farthest position within a movable range with respect to the support portion. In this case, even when the movable mirror portion has moved to the farthest position within the movable range with respect to the support portion, hindrance to operation of the movable mirror portion due to dust which has entered the inside of the package through the ventilation port can be curbed.

The package may include a main body portion provided with the light incident opening and holding the mirror device, and a window member disposed on the main body portion to cover the light incident opening. The ventilation port may be formed by a gap between the main body portion and the window member. In this case, the ventilation port can be simply formed. In addition, since the ventilation port is positioned near the window member, the temperature and the humidity of air in the vicinity of the window member can be likely to become closer to the temperature and the humidity of air outside the package, and thus occurrence of dew condensation can be further curbed.

A protrusion portion may be provided on a top surface of the main body portion. The window member may be disposed on the top surface so as to be in contact with the protrusion portion. The gap may be formed between the top surface and the window member. In this case, the ventilation port can be more simply formed.

The package may include a main body portion provided with the light incident opening and holding the mirror device, and a window member disposed on the main body portion to cover the light incident opening. The ventilation port may be formed by bonding a part of the window member to the main body portion while a remaining part of the window member is not bonded to the main body portion. In this case, the ventilation port can be simply formed.

The ventilation port may be formed by the light incident opening. In this case, the ventilation port can be simply formed. In addition, since the light incident opening also serves as a ventilation port, dew condensation can be effectively curbed.

The ventilation port may be covered with a peelable film. In this case, dust can be prevented from entering the inside of the package through the ventilation port at the time of carrying the mirror unit, or the like. In addition, when the mirror unit is used, the ventilation port can be open by peeling off the film.

The package may include a main body portion provided with the light incident opening and holding the mirror device. The ventilation port may be formed by the light incident opening. The ventilation port may be covered with a peelable film adhered to the main body portion. A width of the film adhered to the main body portion may be smaller than a width of the light incident opening. In this case, since the ventilation port is formed by the light incident opening, the ventilation port can be simply formed. In addition, since the light incident opening also serves as a ventilation port, dew condensation can be effectively curbed. In addition, since the ventilation port is covered with the peelable film, dust can be prevented from entering the inside of the package through the ventilation port at the time of carrying the mirror unit, or the like. When the mirror unit is used, the ventilation port can be open by peeling off the film. Moreover, since the width of the film adhered to the main body portion is smaller than the width of the light incident opening, the film is easily peeled off, and thus an adhesive is unlikely to remain in the main body portion.

### Advantageous Effects of Invention

According to the aspect of the present disclosure, it is possible to provide a mirror unit in which occurrence of dew condensation inside a package can be curbed.

### Brief Description of Drawings

FIG. 1 is a plan view of a mirror unit according to an embodiment.
FIG. 2 is a cross-sectional view along line II-II in FIG. 1.
FIG. 3 is a cross-sectional view along line III-III in FIG. 1.
FIG. 4 is a cross-sectional view along IV-IV in FIG. 1.
FIG. 5 is a plan view of a light scanning device.
FIG. 6 is a plan view of a light scanning device according to another example.
FIG. 7 is a plan view of a light scanning device according to another example.
FIG. 8 is a cross-sectional view along line XIII-XIII in FIG. 7.
FIG. 9 is a cross-sectional view of a mirror unit according to a first modification example.
FIG. 10 is a cross-sectional view of a mirror unit according to a second modification example.

### Description of Embodiment

Hereinafter, an embodiment of the present disclosure will be described in detail with reference to the drawings. In the following description, the same reference signs are used for elements which are the same or corresponding, and duplicate description thereof will be omitted.

### [Overall configuration of mirror unit]

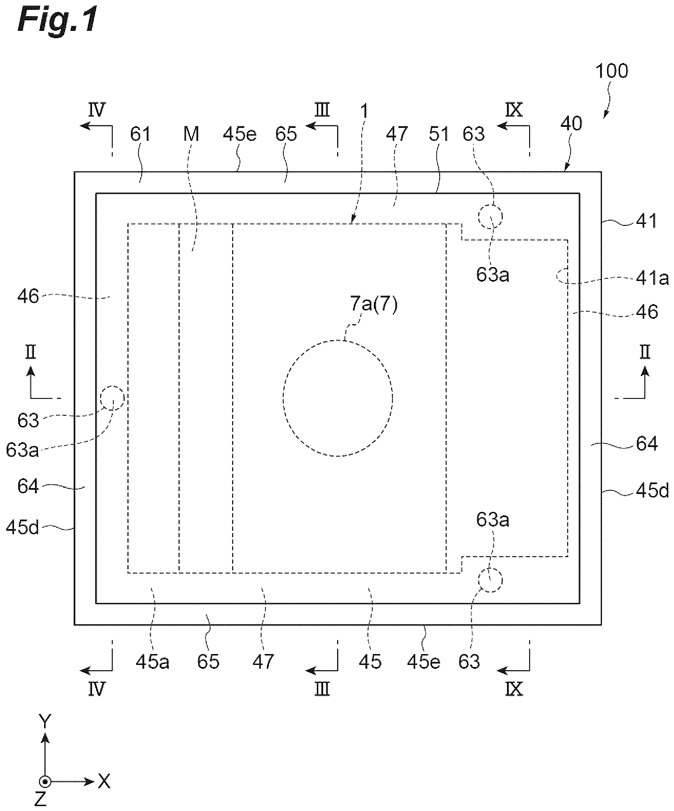

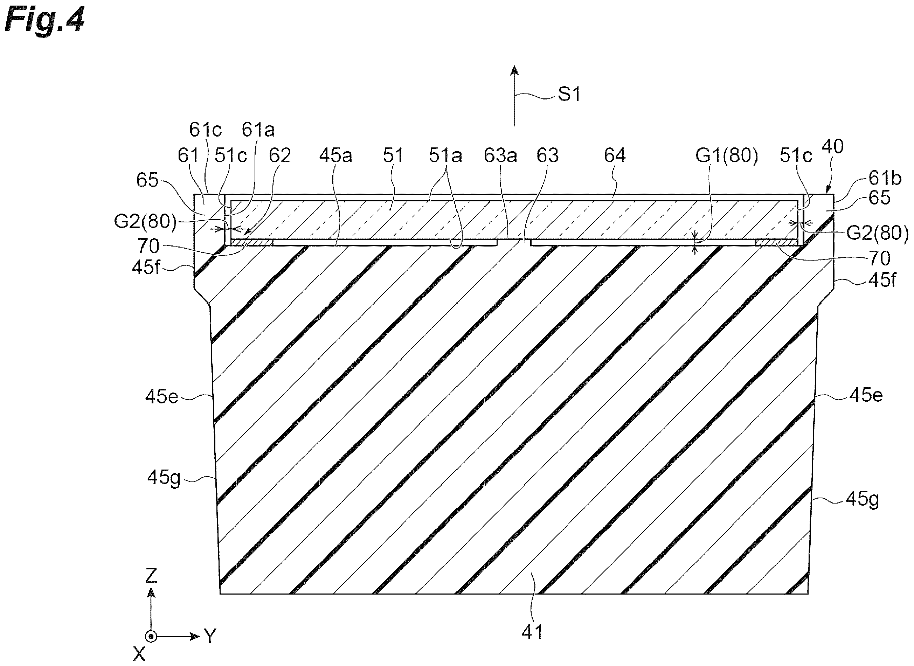

As illustrated in FIGS. 1 to 4, a mirror unit 100 includes a light scanning device (mirror device) 1, and a package 40 accommodating the light scanning device 1. The package 40 has a main body portion 41 and a window member 51. The main body portion 41 is provided with a light incident opening 41a that opens on one side S1 in a predetermined direction (Z axis direction). The main body portion 41 holds the light scanning device 1 such that light incident from the light incident opening 41a can be incident on the light scanning device 1. The window member 51 is disposed such that the light incident opening 41a is covered.

### [Configuration of light scanning device]

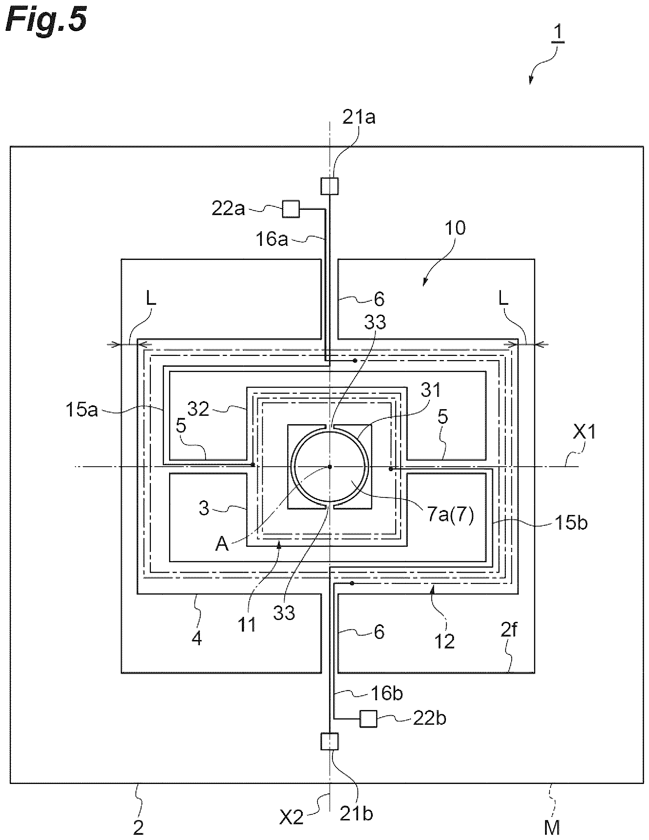

As illustrated in FIG. 5, the light scanning device 1 has a support portion 2, a movable mirror portion 10 which can swing with respect to the support portion 2, and a magnetic field generation portion M. The movable mirror portion 10 has a first movable portion 3, a second movable portion 4, a pair of first joint portions 5, a pair of second joint portions 6, and a mirror 7. The support portion 2, the first movable portion 3, the second movable portion 4, the pair of first joint portions 5, and the pair of second joint portions 6 are integrally formed on a silicon-on-insulator (SOI) substrate, for example. Namely, the light scanning device 1 is configured as a MEMS device. For example, the magnetic field generation portion M is configured to include permanent magnetics in a Halbach array and is formed to have substantially a rectangular parallelepiped shape.

For example, the first movable portion 3 is formed to have a rectangular plate shape. The second movable portion 4 is formed to have a rectangular ring shape, for example, such that the first movable portion 3 is surrounded via a gap when viewed in an optical axis direction A. The support portion 2 is formed to have a rectangular frame shape, for example, such that the second movable portion 4 is surrounded via a gap when viewed in the optical axis direction A. Namely, the support portion 2 is formed to have a frame shape such that the first movable portion 3 and the second movable portion 4 are surrounded when viewed in the optical axis direction A.

The first movable portion 3 is joined to the second movable portion 4 via the pair of first joint portions 5 such that it can swing around a first axis X1. Namely, the first movable portion 3 is supported by the support portion 2 such that it can swing around the first axis XI. The first movable portion 3 includes a first part 31 and a second part 32. The first part 31 is formed to have a circular shape, for example, when viewed in the optical axis direction A. The second part 32 is formed to have a rectangular ring shape, for example, when viewed in the optical axis direction A. The first part 31 is surrounded by the second part 32 when viewed in the optical axis direction A and is connected to the second part 32 via a plurality of (two in this example) connection parts 33. Namely, a gap is formed between the first part 31 and the second part 32 excluding the plurality of connection parts 33.

For example, the connection parts 33 are positioned at middle portions of two sides intersecting a second axis X2 in inner edges of the rectangular shape of the second part 32. That is, in this example, the connection parts 33 are positioned on the second axis X2. The first part 31 need only be connected to the second part 32 in at least a direction along the second axis X2.

The second movable portion 4 is joined to the support portion 2 via the pair of second joint portions 6 such that it can swing around the second axis X2. Namely, the second movable portion 4 is supported by the support portion 2 such that it can swing around the second axis X2. The first axis XI and the second axis X2 are perpendicular to the optical axis direction A and intersect each other (orthogonal to each other in this example). The first part 31 may be formed to have a rectangular shape or a polygonal shape when viewed in the optical axis direction A. The first part 31 may be formed to have a circular shape (for example, an elliptical shape) when viewed in the optical axis direction A. The second part 32 may be formed to have a polygonal ring shape that is a pentagonal shape or a shape having more angles, or an annular shape when viewed in the optical axis direction A.

The pair of first joint portions 5 are disposed on the first axis XI such that the first movable portion 3 is sandwiched therebetween in a gap between the second part 32 of the first movable portion 3 and the second movable portion 4. Each of the first joint portions 5 functions as a torsion bar. The pair of second joint portions 6 are disposed on the second axis X2 such that the second movable portion 4 is sandwiched therebetween in a gap between the second movable portion 4 and the support portion 2. Each of the second joint portions 6 functions as a torsion bar.

The mirror 7 is provided in the first part 31 of the first movable portion 3. The mirror 7 is formed on a surface of the first part 31 on a side opposite to the magnetic field generation portion M such that an intersection between the first axis XI and the second axis X2 is included. For example, the mirror 7 is formed to have a circular, elliptical, or rectangular film shape using a metal material such as aluminum, an aluminum-based alloy, gold, or silver. A surface of the mirror 7 on a side opposite to the first movable portion 3 constitutes a mirror surface 7a extending perpendicularly to the optical axis direction A. The center of the mirror 7 coincides with the intersection between the first axis XI and the second axis X2 when viewed in the optical axis direction A. In this manner, the mirror 7 is provided in the first part 31 connected to the second part 32 via the plurality of connection parts 33. Therefore, even if the first movable portion 3 swings around the first axis XI at a resonance frequency level, occurrence of deformation such as warpage in the mirror 7 can be curbed.

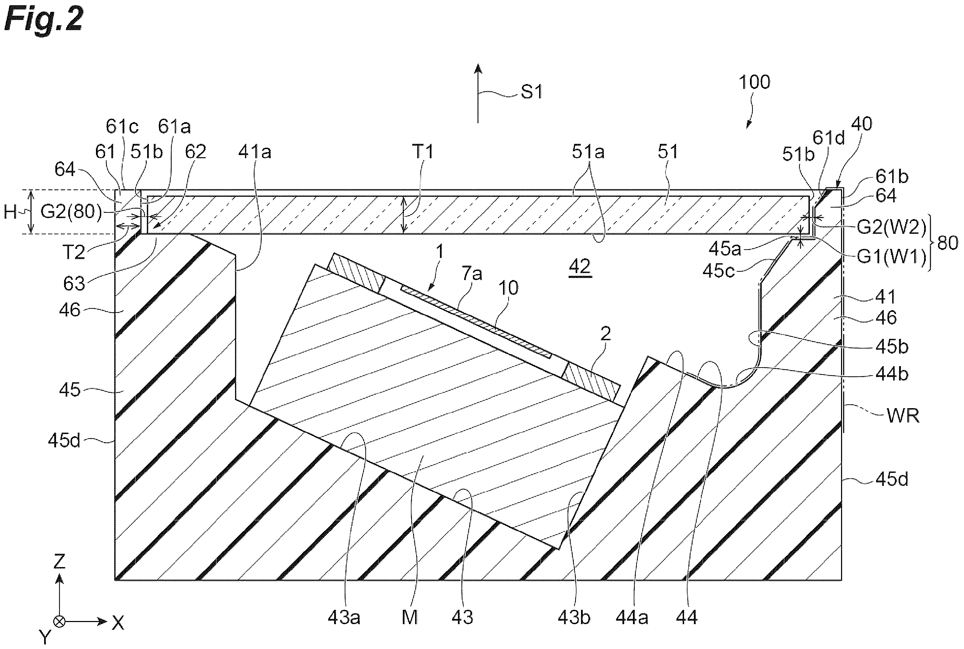

Moreover, the light scanning device 1 has a first driving coil 11, a second driving coil 12, wirings 15a and 15b, wirings 16a and 16b, electrode pads 21a and 21b, and electrode pads 22a and 22b. In FIG. 2, for the sake of convenience of description, the first driving coil 11 and the second driving coil 12 are indicated by one-dot dashed lines, and the wirings 15a and 15b and the wirings 16a and 16b are indicated by solid lines.

The first driving coil 11 is provided in the second part 32 of the first movable portion 3. The first driving coil 11 is wound a plurality of times in a spiral shape (helical shape) in a region of the mirror 7 on an outward side (that is, the second part 32) when viewed in the optical axis direction A. A magnetic field generated by the magnetic field generation portion M acts on the first driving coil 11.

The first driving coil 11 is disposed inside a groove formed on a surface of the first movable portion 3. Namely, the first driving coil 11 is embedded into the first movable portion 3. One end of the first driving coil 11 is connected to the electrode pad 21a via the wiring 15a. The wiring 15a extends from the first movable portion 3 to the support portion 2 via the first joint portion 5 on one side, the second movable portion 4, and the second joint portion 6 on one side. For example, the wiring 15a and the electrode pad 21a are integrally formed of a metal material such as tungsten, aluminum, gold, silver, copper, or an aluminum-based alloy. The first driving coil 11 and the wiring 15a are connected to each other.

The other end of the first driving coil 11 is connected to the electrode pad 21b via the wiring 15b. The wiring 15b extends from the first movable portion 3 to the support portion 2 via the first joint portion 5 on the other side, the second movable portion 4, and the second joint portion 6 on the other side. For example, the wiring 15b and the electrode pad 21b are integrally formed of a metal material such as tungsten, aluminum, gold, silver, copper, or an aluminum-based alloy. The first driving coil 11 and the wiring 15b are connected to each other.

The second driving coil 12 is provided in the second movable portion 4. The second driving coil 12 is wound a plurality of times in a spiral shape (helical shape) in the second movable portion 4. A magnetic field generated by the magnetic field generation portion M acts on the second driving coil 12. The second driving coil 12 is disposed inside a groove formed on a surface of the second movable portion 4. Namely, the second driving coil 12 is embedded into the second movable portion 4.

One end of the second driving coil 12 is connected to the electrode pad 22a via the wiring 16a. The wiring 16a extends from the second movable portion 4 to the support portion 2 via the second joint portion 6 on one side. For example, the wiring 16a and the electrode pad 22a are integrally formed of a metal material such as tungsten, aluminum, gold, silver, copper, or an aluminum-based alloy. The second driving coil 12 and the wiring 16a are connected to each other.

The other end of the second driving coil 12 is connected to the electrode pad 22b via the wiring 16b. The wiring 16b extends from the second movable portion 4 to the support portion 2 via the second joint portion 6 on the other side. For example, the wiring 16b and the electrode pad 22b are integrally formed of a metal material such as tungsten, aluminum, gold, silver, copper, or an aluminum-based alloy. The second driving coil 12 and the wiring 16b are connected to each other.

Examples of operation of the movable mirror portion 10 in the light scanning device 1 will be presented. Regarding a first example, a high-frequency driving current is applied to the first driving coil 11. At this time, a magnetic field generated by the magnetic field generation portion M acts on the first driving coil 11. Therefore, a Lorentz force is generated in the first driving coil 11. Accordingly, for example, the first movable portion 3 is caused to swing around the first axis XI at a resonance frequency level.

In addition, a driving current having a certain magnitude is applied to the second driving coil 12. At this time, a magnetic field generated by the magnetic field generation portion M acts on the second driving coil 12. Therefore, a Lorentz force is generated in the second driving coil 12. Accordingly, for example, the second movable portion 4 is rotated around the second axis X2 in accordance with the magnitude of a driving current and is stopped in this state. Accordingly, according to the light scanning device 1, scanning can be performed while light from a predetermined light source is reflected by the mirror 7. Light is incident on the mirror surface 7a from the outside through the window member 51, is reflected by the mirror surface 7a, and is emitted to the outside through the window member 51. In the first example, the first movable portion 3 is caused to swing at a resonance frequency, and the second movable portion 4 is used statically.

Regarding a second example, similar to operation of the first movable portion 3 in the first example, the first movable portion 3 is caused to swing in accordance with a resonance frequency due to a high-frequency driving current applied to the first driving coil 11, and the second movable portion 4 is caused to swing in accordance with a resonance frequency due to a high-frequency driving current applied to the second driving coil 12. In this manner, in the second example, both the first movable portion 3 and the second movable portion 4 are caused to swing at a resonance frequency.

Regarding a third example, similar to operation of the second movable portion 4 in the first example, the first movable portion 3 is rotated around the first axis XI in accordance with the magnitude of a driving current due to a driving current having a certain magnitude applied to the first driving coil 11 and is stopped, and the second movable portion 4 is rotated around the second axis X2 in accordance with the magnitude of a driving current due to a driving current having a certain magnitude applied to the second driving coil 12 and is stopped. In this manner, in the third example, both the first movable portion 3 and the second movable portion 4 are used statically.

Regarding a fourth example, for example, in such a case where the second movable portion 4 is not provided, only the first movable portion 3 is caused to swing in accordance with a resonance frequency due to a high-frequency driving current applied to the first driving coil 11. Moreover, regarding a fifth example, in a similar case, the first movable portion 3 is rotated around the first axis XI in accordance with the magnitude of a driving current due to a driving current having a certain magnitude applied to the first driving coil 11 and is stopped. In the fourth example and the fifth example, only the first movable portion 3 is driven.

As illustrated in FIG. 2, the support portion 2 is supported by the magnetic field generation portion M, and the first movable portion 3 and the second movable portion 4 are separated from the magnetic field generation portion M. Accordingly, the first movable portion 3 and the second movable portion 4 can rotate without interfering with the magnetic field generation portion M.

### [Configuration of package]

As illustrated in FIGS. 1 to 4, the main body portion 41 of the package 40 is formed to have substantially a rectangular parallelepiped shape, for example. The main body portion 41 is formed of a resin material such as polyphenylene sulfide (PPS) or polypropylene (PP), for example, and is formed through injection molding. The main body portion 41 may be subjected to filler reinforcement when it is formed of a resin material. The main body portion 41 may be formed of a metal material such as Al, Fe, or an alloy thereof. A recessed portion 42 opening on the one side S1 is formed in the main body portion 41. The light incident opening 41a described above is configured by an opening of the recessed portion 42.

For example, the window member 51 is configured by forming an antireflective film on both surfaces of a rectangular flat plate-shaped base material formed of a translucent material such as glass. As described above, the window member 51 covers the light incident opening 41a. The window member 51 has a pair of main surfaces 51a extending perpendicularly to the Z axis direction, a pair of side surfaces 51b extending perpendicularly to an X axis direction, and a pair of side surfaces 51c extending perpendicularly to a Y axis direction. The pair of side surfaces 51b and the pair of side surfaces 51c continue to the pair of main surfaces 51a.

The recessed portion 42 of the main body portion 41 includes a device disposition portion 43 in which the light scanning device 1 is disposed, and a wiring disposition portion 44 in which wirings extending to the outside from the light scanning device 1, and the like are disposed. The device disposition portion 43 has a first surface 43a extending so as to be inclined with respect to the main surfaces 51a of the window member 51, a second surface 43b extending perpendicularly to the first surface 43a from the first surface 43a, and a pair of third surfaces 43c extending perpendicularly to the Z axis direction from the first surface 43a.

The light scanning device 1 is disposed in the device disposition portion 43 in a state where the magnetic field generation portion M is in contact with the first surface 43a, the second surface 43b, and the pair of third surfaces 43c. Accordingly, the light scanning device 1 is in a state where the mirror surface 7a of the movable mirror portion 10 is inclined with respect to the main surfaces 51a of the window member 51. For example, the light scanning device 1 is disposed such that the first axis XI is parallel to the X axis direction and the second axis X2 is parallel to the Y axis direction.

The wiring disposition portion 44 has a first surface 44a which is inclined with respect to the main surfaces 51a of the window member 51, and a second surface 44b which continues to the first surface 44a and is curved. For example, a plurality of electrode pads are disposed on the first surface 44a. The wirings extending from the light scanning device 1 and a wiring WR passing through the second surface 44b and extending to the outside of the package 40 are electrically connected to these electrode pads. The wiring WR is electrically connected to an external terminal disposed outside the mirror unit 100. In this example, the wiring WR is provided on a surface of the main body portion 41 and extends to the outside but it may pass through the inside of the main body portion 41 and extend to the outside. The wiring WR may be electrically connected to one end of a lead terminal having the one end embedded into the main body portion and the other end exposed to the outside of the package 40. The second surface 44b may not necessarily be curved.

The light incident opening 41a exhibits substantially a rectangular shape when viewed in the Z axis direction (in other words, when viewed in a direction perpendicular to the main surfaces 51a of the window member 51). More specifically, the light incident opening 41a includes a rectangular region corresponding to the device disposition portion 43 and a rectangular region corresponding to the wiring disposition portion 44 when viewed in the Z axis direction. A width of the region corresponding to the wiring disposition portion 44 in the Y axis direction is smaller than a width of the region corresponding to the device disposition portion 43 in the Y axis direction. In FIG. 1, an edge of the light incident opening 41a is indicated by a dotted line.

The main body portion 41 has a frame-shaped side wall 45 defining the recessed portion 42. The side wall 45 exhibits substantially a rectangular ring shape and surrounds the light scanning device 1 when viewed in the Z axis direction. The side wall 45 has a top surface 45a positioned farthest on the one side S1, an inner surface 45b extending along the Z axis direction, and an inclined surface 45c connected to the top surface 45a and the inner surface 45b. The top surface 45a extends perpendicularly to the Z axis direction, and the inclined surface 45c extends in a manner of being inclined with respect to the Z axis direction such that it goes closer to the one side S1 as it goes closer to the top surface 45a.

In addition, the side wall 45 has a pair of outer surfaces 45d extending along a plane intersecting the X axis direction, and a pair of outer surfaces 45e extending along a plane intersecting the Y axis direction. In this example, the pair of outer surfaces 45d extend perpendicularly to the X axis direction. Each of the pair of outer surfaces 45e includes a first part 45f extending in a manner of being parallel to the Z axis direction, and a second part 45g extending in a manner of being inclined with respect to the Z axis direction. The side wall 45 has a pair of first wall portions 46 facing each other in the X axis direction, and a pair of second wall portions 47 facing each other in the Y axis direction.

The second parts 45g are disposed on the other side with respect to the first parts 45f (a side opposite to the one side S1) and extend to an end portion of the main body portion 41 on the other side. Since the second parts 45g are formed, the width of the main body portion 41 (side wall 45) in the Y axis direction becomes smaller as it goes closer to the other side. Accordingly, when the main body portion 41 is formed by injection molding, a molded product can be easily taken out from a molding die. In addition, since not only the second parts 45g but also the first parts 45f parallel to the Z axis direction are formed, the mirror unit 100 can be positionally aligned by pressing the first parts 45f when the mirror unit 100 is incorporated into an optical system, and thus positional alignment accuracy of the mirror unit 100 can be improved.

The package 40 further has a protrusion 61 provided on the top surface 45a of the side wall 45. The protrusion 61 extends along the edge of the light incident opening 41a. The protrusion 61 exhibits a rectangular ring shape and surrounds the light incident opening 41a when viewed in the Z axis direction. Since the protrusion 61 is formed, a stepped portion 62 is formed between an inner surface 61a of the protrusion 61 and the top surface 45a.

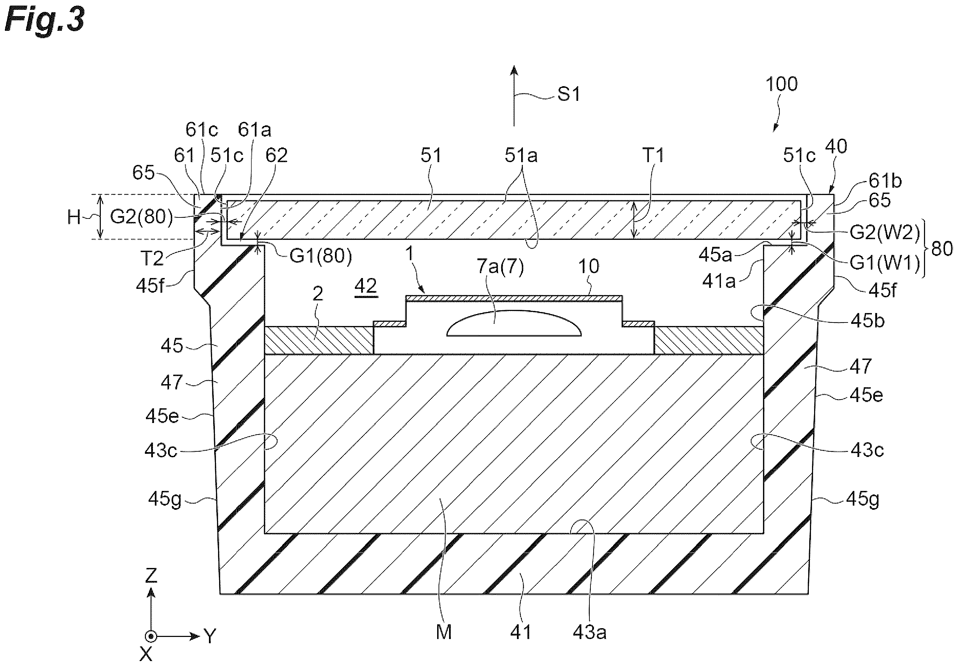

The protrusion 61 extends along an outer edge of the top surface 45a. When viewed in the Y axis direction (FIG. 2), outer surfaces 61b of the protrusion 61 are positioned on the same plane as the outer surfaces 45d of the side wall 45. When viewed in the X axis direction (FIG. 3), the outer surfaces 61b of the protrusion 61 are positioned on the same plane as the first parts 45f on the outer surfaces 45e of the side wall 45. For example, the protrusion 61 is formed of the same resin material as the main body portion 41 and is integrally formed with the main body portion 41. For example, the main body portion 41 and the protrusion 61 are formed at the same time through single injection molding and constitute a single member. The protrusion 61 has a pair of first parts 64 respectively provided on the pair of first wall portions 46 of the side wall 45, and a pair of second parts 65 respectively provided on the pair of second wall portions 47 of the side wall 45.

Three protrusion portions (abutment portions) 63 are provided on the top surface 45a of the side wall 45. Each of the protrusion portions 63 is disposed on an inward side than the protrusion 61 when viewed in the Z axis direction. Each of the protrusion portions 63 has a flat abutment surface 63a facing the one side S1. For example, the abutment surface 63a extends perpendicularly to the Z axis direction and exhibits a circular shape.

The window member 51 is disposed at the stepped portion 62 such that the light incident opening 41a is covered. That is, the window member 51 is disposed on the top surface 45a on the inward side of the protrusion 61 and covers the light incident opening 41a. One of the pair of main surfaces 51a of the window member 51 (which may hereinafter be simply stated as the main surface 51a) faces the top surface 45a of the side wall 45, and the side surfaces 51b and 51c of the window member 51 face the inner surface 61a of the protrusion 61. The main surfaces 51a of the window member 51 are in contact with (are caused to abut) the abutment surfaces 63a of the protrusion portions 63. Accordingly, in a region where the abutment surfaces 63a are not provided on the top surface 45a, gaps G1 are formed between the main surfaces 51a of the window member 51 and the top surface 45a. In addition, gaps G2 are formed between the side surfaces 51b and 51c of the window member 51 and the inner surface 61a of the protrusion 61. That is, the side surfaces 51b and 51c are apart from the inner surface 61a.

The gaps G1 and the gaps G2 are connected to each other. The gaps G1 and G2 form a ventilation port 80 communicating the inside and the outside of the package 40. That is, the ventilation port 80 is formed by the gaps G1 and G2 between the main body portion 41 and the window member 51. Due to the ventilation port 80, air circulation between the inside and the outside of the package 40 is enabled.

For example, the window member 51 is bonded to the main body portion 41 using a bonding material 70 such as a low melting point glass. For example, the window member 51 is bonded to the main body portion 41 at four corner portions when viewed in the Z axis direction. In addition to or in place of four corner portions, the window member 51 may be bonded to the main body portion 41 using a bonding material at contact parts with the abutment surfaces 63a. At a location where the window member 51 is bonded to the main body portion 41, a space between the main body portion 41 and the window member 51 is blocked by the bonding material 70, and the gap G1 (ventilation port 80) is not formed between the main body portion 41 and the window member 51. Meanwhile, at a location where the window member 51 is not bonded to the main body portion 41, the gap G1 (ventilation port 80) is formed between the main body portion 41 and the window member 51. That is, the ventilation port 80 can be considered to be formed by bonding a part of the window member 51 to the main body portion 41 while the remaining part of the window member 51 is not bonded to the main body portion 41.

An end surface 61c of the protrusion 61 on the one side S1 is positioned more to the one side S1 than the window member 51 throughout the whole circumference (at any position on the end surface 61c). That is, a height H of the protrusion 61 from the top surface 45a is larger than the sum of a thickness (distance between the pair of main surfaces 51a) T1 of the window member 51 and a height of the protrusion portions 63 from the top surface 45a (length of the gaps G1 in the Z axis direction). For example, the thickness T1 of the window member 51 is approximately 0.6 mm.

A thickness T2 of the protrusion 61 is smaller than the height H of the protrusion 61 from the top surface 45a. The thickness T2 of the protrusion 61 is smaller than the thickness T1 of the window member 51. The thickness T2 of the protrusion 61 is a thickness in a direction perpendicular to an extending direction of the protrusion 61. For example, it is a thickness in the X axis direction at a part extending perpendicularly to the X axis direction in the protrusion 61, and it is a thickness in the Y axis direction at a part extending perpendicularly to the Y axis direction. The thickness T2 of the protrusion 61 is the largest thickness of the protrusion 61. For example, when a part of the protrusion 61 is formed to have a tapered shape as in the embodiment, the thickness T2 of the protrusion 61 is a thickness of the thickest part in the protrusion 61. In this example, one of a pair of parts in the protrusion 61 extending in the Y axis direction is formed to have a tapered shape and has an inclined surface 61d. Accordingly, work of disposing the window member 51 in the stepped portion 62 can be facilitated. In addition, the protrusion 61 can be likely to be subjected to warp deformation.

### [Configuration of ventilation port]

A smallest width W of the ventilation port 80 is smaller than a smallest distance L between the movable mirror portion 10 and a part whose position is fixed in the mirror unit 100.

First, the smallest width W of the ventilation port 80 will be described. When a direction toward the outside from the inside of the package 40 in the ventilation port 80 is regarded as the extending direction, the smallest width W of the ventilation port 80 is the smallest width in a cross section perpendicular to the extending direction. When the ventilation port 80 is formed by the gaps G1 and G2 as in the embodiment, the extending direction at parts formed between the window member 51 and the first wall portions 46 of the side wall 45 in the gaps G1 is the X axis direction (FIG. 2), and the extending direction at parts formed between the window member 51 and the second wall portions 47 of the side wall 45 in the gaps G1 is the Y axis direction (FIG. 3). The extending direction of the ventilation port 80 in the gaps G2 is the Z axis direction.

In the embodiment, smallest widths W1 of the gaps G1 are widths of the gaps G1 in the Z direction. Smallest widths W2 of the gaps G2 are widths of the gaps G2 in the X direction at parts formed between the window member 51 and the first parts 64 of the protrusion 61 in the gaps G2 (FIG. 2) and are widths of the gaps G2 in the Y direction at parts formed between the window member 51 and the second parts 65 of the protrusion 61 in the gaps G2 (FIG. 3). In this example, the smallest widths W1 of the gaps G1 are the same throughout the entirety of the gaps G1 in the extending direction, and the smallest widths W2 of the gaps G2 are the same throughout the entirety of the gaps G2 in the extending direction. The smallest widths W1 are equivalent to the smallest widths W2. Therefore, the smallest width W of the ventilation port 80 is equivalent to the smallest widths W1 of the gaps G1 and the smallest widths W2 of the gaps G2. When the smallest widths W1 are smaller than the smallest widths W2, the smallest width W of the ventilation port 80 is the smallest width W1, and when the smallest widths W2 are smaller than the smallest widths W1, the smallest width W of the ventilation port 80 is the smallest width W2.

In the embodiment, the shapes of the gaps G1 in a cross section perpendicular to the extending direction are uniform in the extending direction, but the shapes of the gaps G1 in a cross section perpendicular to the extending direction may vary in the extending direction. In this case, the smallest widths W1 of the gaps G1 are the smallest width in a cross section in which the smallest width is the narrowest. Unlike the embodiment, when the smallest widths of the gaps G1 in the Y direction are smaller than the smallest widths of the gaps G1 in the Z direction, the smallest widths W1 of the gaps G1 are widths of the gaps G1 in the Y direction. The same also applies to the gaps G2.

The smallest distance L is the smallest distance between the movable mirror portion 10 and the part whose position is fixed in the mirror unit 100. In the embodiment, the part whose position is fixed in the mirror unit 100 indicates all the elements other than the movable mirror portion 10 in the mirror unit 100 and specifically indicates the support portion 2 and the magnetic field generation portion M of the light scanning device 1, and the package 40.

In the light scanning device 1 illustrated in FIG. 5, the smallest distance L is the smallest distance between the support portion 2 and the second movable portion 4 when viewed in the optical axis direction A (direction perpendicular to the mirror 7) and is a distance between the support portion 2 and the second movable portion 4 in a direction parallel to the first axis XI.

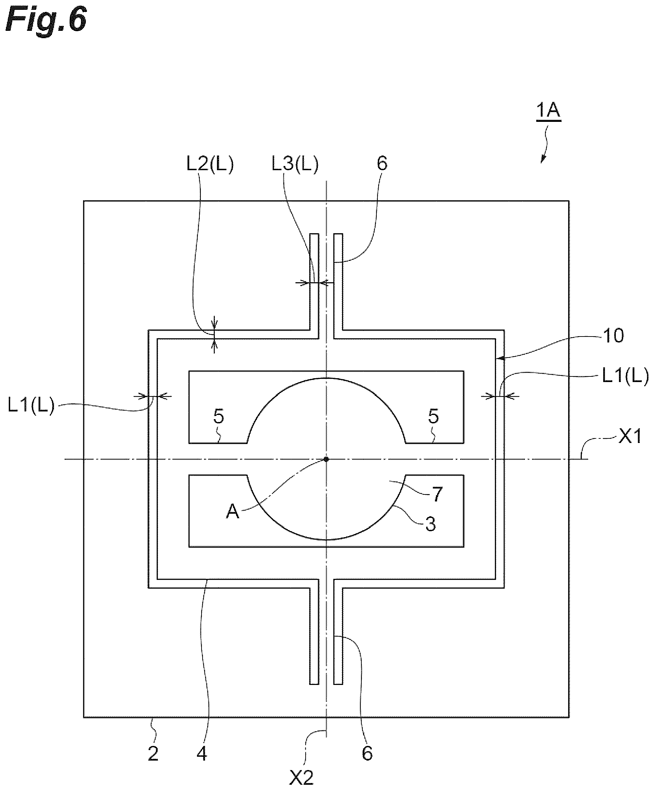

In a light scanning device 1A illustrated in FIG. 6, the smallest distance L is the smallest distance between the support portion 2 and the second movable portion 4 when viewed in the optical axis direction A and is a distance L1 between the support portion 2 and the second movable portion 4 in a direction parallel to the first axis XI. In this example, the distance L1 is equivalent to a distance L2 between the support portion 2 and the second movable portion 4 in a direction parallel to the second axis X2, and distances L3 between the support portion 2 and the second joint portions 6 in a direction parallel to the first axis X1. When the distances L1, L2, and L3 differ from each other, the smallest distance L is the shortest distance of the distances L1, L2, and L3. The distances between the support portion 2 and the second joint portions 6 indicate distances in a direction perpendicular to the extending direction of the second joint portions 6. In the example of FIG. 6, the first movable portion 3 is formed to have a circular plate shape.

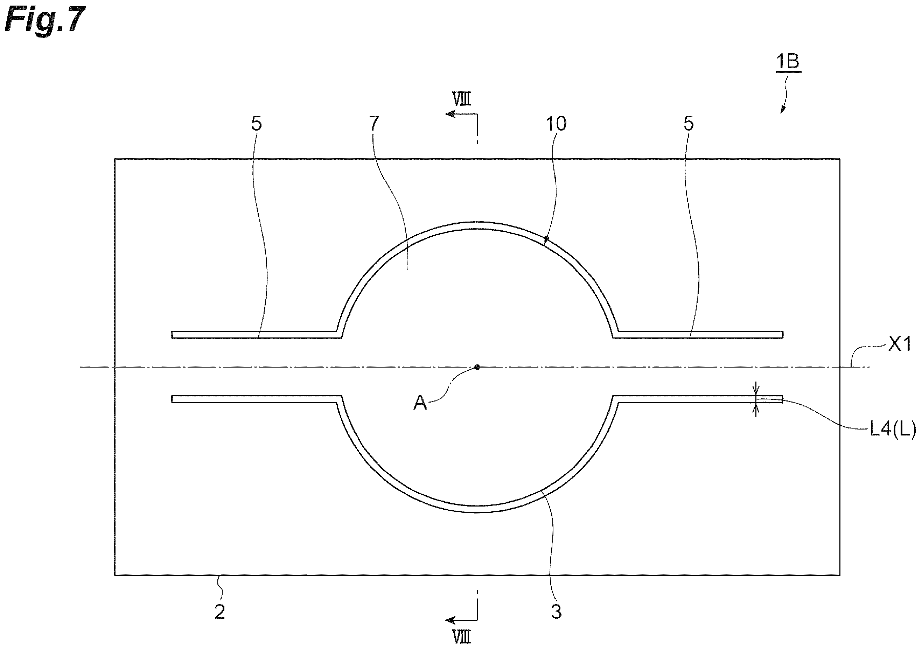

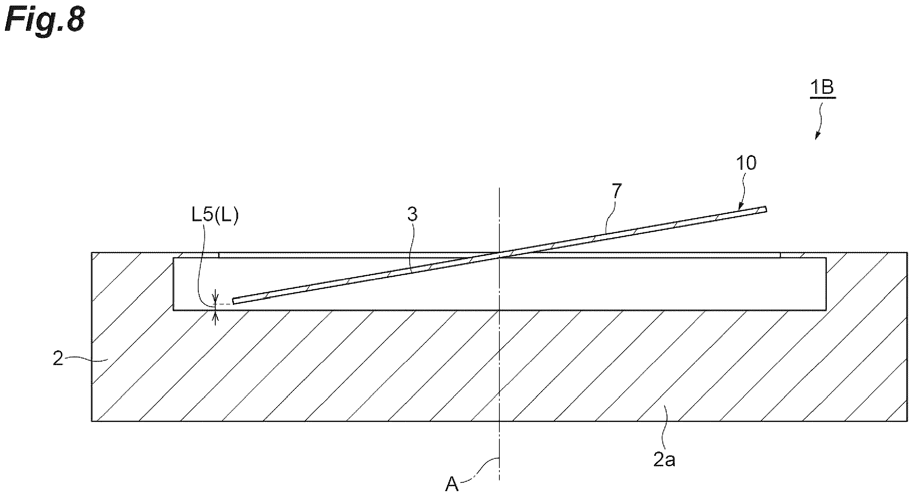

In a light scanning device 1B illustrated in FIGS. 7 and 8, the second movable portion 4 and the second joint portions 6 are not provided, and the first movable portion 3 is joined to the support portion 2 via the first joint portions 5. The movable mirror portion 10 swings around only the first axis XI. The first movable portion 3 is formed to have a circular shape. The support portion 2 has a flat plate-shaped base portion 2a extending in a manner of facing the first movable portion 3 (movable mirror portion 10). The base portion 2a is disposed such that the movable mirror portion 10 (first movable portion 3) does not come into contact with the base portion 2a even when the movable mirror portion 10 has rotated to a maximum deflection angle around the first axis XI.

In the light scanning device 1B, the smallest distance between the support portion 2 and the movable mirror portion 10 when viewed in the optical axis direction A will be regarded as L4. For example, the smallest distance L4 is a distance between the support portion 2 and the first joint portions 5 in a direction perpendicular to the optical axis direction A and the first axis X1. In this example, the distances between the support portion 2 and the first joint portions 5 are equivalent to a distance between the support portion 2 and the first movable portion 3 (shortest distance). The distances between the support portion 2 and the first joint portions 5 are distances in a direction perpendicular to the extending direction of the first joint portions 5.

FIG. 8 illustrates a state where the movable mirror portion 10 has rotated to the maximum deflection angle around the first axis XI with respect to the support portion 2 (has moved to the farthest position within a movable range). In the light scanning device 1B, the smallest distance between the movable mirror portion 10 and the support portion 2 when the movable mirror portion 10 has rotated to the maximum deflection angle around the first axis X1 with respect to the support portion 2 will be regarded as L5. For example, the smallest distance L5 is the smallest distance between the first movable portion 3 and the base portion 2a of the support portion 2 in the optical axis direction A. As illustrated in FIG. 2, when the movable mirror portion 10 faces the magnetic field generation portion M, the smallest distance L5 is the smallest distance between the movable mirror portion 10 and the magnetic field generation portion M in the optical axis direction A. Regarding another example, when the movable mirror portion 10 faces the main body portion 41 of the package 40, the smallest distance L5 is the smallest distance between the movable mirror portion 10 and the main body portion 41 in the optical axis direction A when the movable mirror portion 10 has rotated to the maximum deflection angle.

In the light scanning device 1B, the smallest distance L is the shorter distance of the smallest distances L5 and L6. In this example, the smallest distance L5 is equivalent to the smallest distance L6. In other words, the smallest distance L5 is the smallest distance between the support portion 2 and the movable mirror portion 10 in a state where the movable mirror portion 10 has not rotated (moved) with respect to the support portion 2. In other words, the smallest distance L is the smallest distance between the support portion 2 and the movable mirror portion 10 when the movable mirror portion 10 rotates within a rotatable range with respect to the support portion 2.

In any case where the mirror unit 100 includes any of the light scanning devices 1, 1A, and 1B, the smallest width W of the ventilation port 80 is smaller than the smallest distance L between the movable mirror portion 10 and the part whose position is fixed in the mirror unit 100. Accordingly, hindrance to operation of the movable mirror portion 10 due to dust which has entered the inside of the package 40 through the ventilation port 80 can be curbed.

### [Functions and effects]

As described above, the ventilation port 80 communicating the inside and the outside of the package 40 is provided in the package 40 of the mirror unit 100. Accordingly, ventilation between the inside and the outside of the package 40 can be achieved via the ventilation port 80. As a result, occurrence of dew condensation inside the package 40 can be curbed.

The smallest width W of the ventilation port 80 is smaller than the smallest distance L between the movable mirror portion 10 and the part whose position is fixed in the mirror unit 100. Accordingly, hindrance to operation of the movable mirror portion 10 due to dust which has entered the inside of the package 40 through the ventilation port 80 can be curbed.

The smallest width W of the ventilation port 80 is smaller than the smallest distance L between the support portion 2 and the first movable portion 3 or the second movable portion 4 when viewed in the optical axis direction A. Accordingly, having a situation where dust which has entered the inside of the package 40 through the ventilation port 80 is sandwiched between the support portion 2 and the first movable portion 3 or the second movable portion 4 can be curbed, and thus hindrance to operation of the movable mirror portion 10 due to dust can be curbed.

The smallest width W of the ventilation port 80 is smaller than the smallest distance L between the movable mirror portion 10 and the part whose position is fixed in the mirror unit 100 when the movable mirror portion 10 has moved to the farthest position within the movable range with respect to the support portion 2. Accordingly, even when the movable mirror portion 10 has moved to the farthest position within the movable range with respect to the support portion 2, hindrance to operation of the movable mirror portion 10 due to dust which has entered the inside of the package 40 through the ventilation port 80 can be curbed.

The ventilation port 80 may be formed by the gaps G1 and G2 between the main body portion 41 and the window member 51. Accordingly, for example, compared to the case where the ventilation port 80 is formed b a penetration hole formed in the main body portion 41, the ventilation port 80 can be simply formed. In addition, since the ventilation port 80 is positioned near the window member 51, the temperature and the humidity of air in the vicinity of the window member 51 can be likely to become closer to the temperature and the humidity of air outside the package 40, and thus occurrence of dew condensation can be further curbed.

The window member 51 is disposed on the top surface 45a so as to be in contact with the protrusion portions 63 provided on the top surface 45a of the main body portion 41, and the gaps G1 are formed between the top surface 45a and the window member 51. Accordingly, the ventilation port 80 can be more simply formed. In addition, a contact area between the window member 51 and the main body portion 41 can be reduced, and thus distortion of the window member 51 due to a difference between thermal expansion coefficients of the window member 51 and the main body portion 41 can be curbed.

The ventilation port 80 is formed by bonding a part of the window member 51 to the main body portion 41 while the remaining part of the window member 51 is not bonded to the main body portion 41. Accordingly, the ventilation port 80 can be simply formed. In addition, the contact area between the window member 51 and the main body portion 41 can be reduced, and thus distortion of the window member 51 due to a difference between the thermal expansion coefficients of the window member 51 and the main body portion 41 can be curbed.

### [Modification examples]

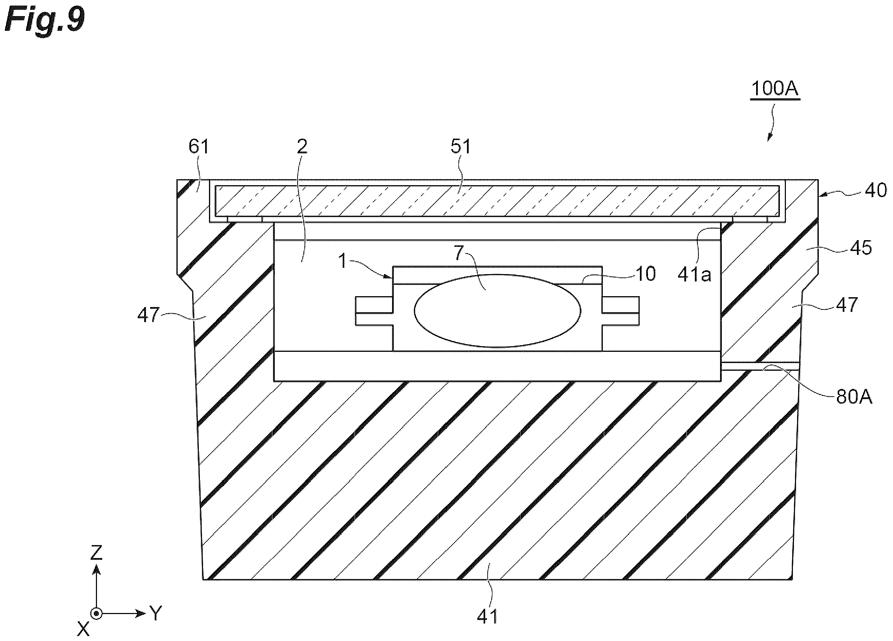

FIG. 9 illustrates a mirror unit 100A according to a first modification example. The cross section illustrated in FIG. 9 corresponds to the cross section along line IX-IX in FIG. 1. In the mirror unit 100A, a ventilation port 80A is formed by a penetration hole formed in the main body portion 41. More specifically, the ventilation port 80A is formed in the second wall portion 47 in the side wall 45 of the main body portion 41 and extends in the Y direction. For example, the ventilation port 80A exhibits a circular shape in a cross section perpendicular to the extending direction. Also in the mirror unit 100A, the smallest width W of the ventilation port 80A is smaller than the smallest distance L between the movable mirror portion 10 and the part at the fixed position in the mirror unit 100. In this case, the smallest width W of the ventilation port 80A is a diameter in a circular cross section perpendicular to the extending direction. The cross-sectional shape of the ventilation port 80A is not limited to a circular shape and may be a rectangular shape, for example. In the first modification example, the gaps G1 and G2 may not be formed between the window member 51 and the main body portion 41, and a space between the window member 51 and the main body portion 41 may be blocked and sealed in an airtight manner.

Also in the first modification example, similar to the foregoing embodiment, ventilation between the inside and the outside of the package 40 can be achieved via the ventilation port 80A. As a result, occurrence of dew condensation inside the package 40 can be curbed.

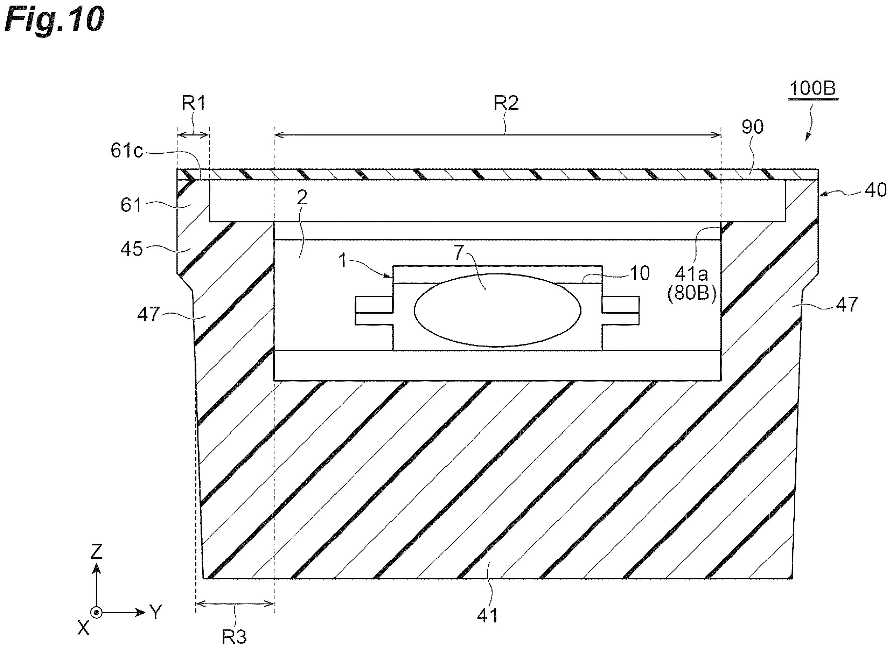

In a mirror unit 100B according to a second modification example illustrated in FIG. 10, a ventilation port 80B is formed by the light incident opening 41a of the main body portion 41. That is, in the mirror unit 100B, the window member 51 is not provided, and the light incident opening 41a is not covered by the window member 51. The ventilation port 80B is covered with a peelable film 90 adhered to the main body portion 41. In this example, the film 90 is adhered to the entire surface of the end surface 61c of the protrusion 61. In a cross section perpendicular to the mirror 7, a width R1 of the film 90 adhered to the main body portion 41 is smaller than a width R2 of the light incident opening 41a. The width R1 is smaller than a thickness (smallest thickness) R3 of the side wall 45 of the main body portion 41.

Also in the second modification example, similar to the foregoing embodiment, ventilation between the inside and the outside of the package 40 can be achieved via the ventilation port 80B. As a result, occurrence of dew condensation inside the package 40 can be curbed. In addition, since the ventilation port 80B is formed by the light incident opening 41a, the ventilation port 80B can be simply formed. In addition, since the light incident opening 41a also serves as the ventilation port 80B, occurrence of dew condensation can be effectively curbed (inherently, dew condensation does not occur). In addition, since an element capable of reflecting light is not disposed on an optical path to the extent that light incident through the light incident opening 41a arrives at the movable mirror portion 10, generation of stray light can be curbed. In addition, since the ventilation port 80B is covered with the peelable film 90, dust can be prevented from entering the inside of the package 40 through the ventilation port 80B at the time of carrying the mirror unit 100B, or the like. When the mirror unit 100B is used, the ventilation port 80B can be open by peeling off the film 90. Moreover, since the width R1 of the film 90 adhered to the main body portion 41 is smaller than the width R2 of the light incident opening 41a, the film 90 is easily peeled off, and thus an adhesive is unlikely to remain in the main body portion 41. In the second modification example, the protrusion 61 may not be provided, and the film 90 may be adhered to the top surface 45a of the side wall 45 of the main body portion 41.

The present disclosure is not limited to the foregoing embodiment and modification examples. For example, a material and a shape of each of the constitutions are not limited to the materials and the shapes described above, and various materials and shapes can be employed. In the foregoing embodiment or the first modification example, the ventilation ports 80 and 80A may be covered with a peelable film. The ventilation port 80 may be formed by a penetration hole formed in the window member 51. In this case, the ventilation port 80 can be considered to be formed by the light incident opening 41a. In the foregoing embodiment, the protrusion portions 63 may not be provided on the top surface 45a of the side wall 45. Even in this case, the ventilation port 80 can be formed by bonding a part of the window member 51 to the main body portion 41 while the remaining part of the window member 51 is not bonded to the main body portion 41. In the foregoing embodiment, the protrusion 61 may not be provided on the top surface 45a of the side wall 45. In this case, the ventilation port 80 may be formed by only the gaps G1.

In the foregoing embodiment and first and second modification examples, the smallest widths W of the ventilation ports 80, 80A, and 80B in a predetermined direction (certain direction) may be smaller than the smallest distance L between the movable mirror portion 10 and the part whose position is fixed in the mirror unit 100. That is, in the foregoing embodiment and first and second modification examples, the smallest widths W of the ventilation ports 80, 80A, and 80B in all directions perpendicular to the extending direction of the ventilation ports 80, 80A, and 80B are smaller than the smallest distance L. However, the smallest widths W of the ventilation ports 80, 80A, and 80B in at least one direction perpendicular to the extending direction of the ventilation ports 80, 80A, and 80B need only be smaller than the smallest distance L, and the smallest widths of the ventilation ports 80, 80A, and 80B in other directions perpendicular to the extending direction are not necessarily smaller than the smallest distance L.

The main body portion 41 need only accommodate and hold the light scanning device 1 such that light incident through the light incident opening 41a can be incident on the light scanning device 1 and may have any configuration. For example, a base portion for supporting the light scanning device 1 may be formed separately from the side wall 45. In the light scanning device 1 according to the embodiment, the movable mirror portion 10 is driven by means of an electromagnetic force. However, the movable mirror portion 10 may be driven by means of an electrostatic force or a piezoelectric element. In the foregoing embodiment, the movable mirror portion 10 is configured such that it can swing (can move) around the first axis XI and the second axis X2. However, the movable mirror portion 10 may be configured such that it can move in the optical axis direction A. In the foregoing embodiment, the magnetic field generation portion M is disposed inside the package 40. However, the magnetic field generation portion M may be disposed outside the package 40.

### Reference Signs List

1: Light scanning device (mirror device), 2: Support portion, 3: First movable portion, 4: Second movable portion, 7: Mirror, 10: Movable mirror portion, 40: Package, 41: Main body portion, 41a: Light incident opening, 45a: Top surface, 51: Window member, 63: Protrusion portion (abutment portion), 80, 80A, 80B: Ventilation port, 90: Film, 100, 100A, 100B: Mirror unit, G1: Gap (ventilation port 80), G2: Gap (ventilation port 80), L: Smallest distance, W: Smallest width

## Claims

1. A mirror unit comprising:
a mirror device including a support portion and a movable mirror portion configured to be movable with respect to the support portion; and
a package including a light incident opening and accommodating and holding the mirror device such that light incident from the light incident opening is able to be incident on the movable mirror portion,
wherein the package is provided with a ventilation port communicating an inside and an outside of the package.

2. The mirror unit according to claim 1,
wherein a smallest width of the ventilation port in a predetermined direction is smaller than a smallest distance between the movable mirror portion and a part whose position is fixed in the mirror unit.

3. The mirror unit according to claim 1 or 2,
wherein the movable mirror portion includes a movable portion and a mirror provided on the movable portion, and
wherein a smallest width of the ventilation port in a predetermined direction is smaller than a smallest distance between the support portion and the movable portion when viewed in a direction perpendicular to the mirror.

4. The mirror unit according to any one of claims 1 to 3,
wherein a smallest width of the ventilation port in a predetermined direction is smaller than a smallest distance between the movable mirror portion and a part whose position is fixed in the mirror unit when the movable mirror portion has moved to a farthest position within a movable range with respect to the support portion.

5. The mirror unit according to any one of claims 1 to 4,
wherein the package includes a main body portion provided with the light incident opening and holding the mirror device, and a window member disposed on the main body portion to cover the light incident opening, and
wherein the ventilation port is formed by a gap between the main body portion and the window member.

6. The mirror unit according to claim 5,
wherein a protrusion portion is provided on a top surface of the main body portion,
wherein the window member is disposed on the top surface so as to be in contact with the protrusion portion, and
wherein the gap is formed between the top surface and the window member.

7. The mirror unit according to any one of claims 1 to 6,
wherein the package includes a main body portion provided with the light incident opening and holding the mirror device, and a window member disposed on the main body portion to cover the light incident opening, and
wherein the ventilation port is formed by bonding a part of the window member to the main body portion while a remaining part of the window member is not bonded to the main body portion.

8. The mirror unit according to any one of claims 1 to 7,
wherein the ventilation port is formed by the light incident opening.

9. The mirror unit according to any one of claims 1 to 8,
wherein the ventilation port is covered with a peelable film.

10. The mirror unit according to claim 1,
wherein the package includes a main body portion provided with the light incident opening and holding the mirror device,
wherein the ventilation port is formed by the light incident opening,
wherein the ventilation port is covered with a peelable film adhered to the main body portion, and
wherein a width of the film adhered to the main body portion is smaller than a width of the light incident opening.
